# EUROPÄISCHE PATENTANMELDUNG

(11) **EP 1 030 370 A2**
(43) Veröffentlichungstag der Anmeldung: **23.08.2000**
(21) Anmeldenummer: 00102588.1
(22) Anmeldetag: 07.02.2000
(51) Int. Cl.: H01L 27/02, H01L 23/528, H01L 27/108

(54) **Integrierte Halbleiterspeicheranordnung mit Selbstpufferung von Versorgungsspannungen**

(30) Priorität: 19.02.1999 DE 19907155
(71) Anmelder: Infineon Technologies AG, 81541 München (DE)
(72) Erfinder: Chrysostomides, Athanasia, 81929 München (DE); Kaiser, Robert, 86916 Kaufering (DE); Feurle, Robert, 85579 Neubiberg (DE); Schneider, Helmut, 80993 München (DE)
(74) Vertreter: Zedlitz, Peter, Dipl.-Ing.

(57) **Zusammenfassung**

Die Erfindung betrifft eine integrierte Halbleiterspeicheranordnung mit mehreren Speicherzellenfeldern (1 bis 8), die untereinander durch niederohmige Versorgungsleitungen (11 bis 14) verbunden sind, welche ein Power-Netzwerk bilden. Dieses Power-Netzwerk ist durch eine hochohmige Versorgungsleitung (10) an einen Spannungsgenerator (9) angeschlossen. Ein aktiviertes Speicherzellenfeld (beispielsweise (6)) wird für diese Aktivierung durch Selbstpufferung aus den übrigen Speicherzellenfeldern (1 bis 5, 7 und 8) versorgt.

## Beschreibung

Die vorliegende Erfindung bezieht sich auf eine integrierte Halbleiterspeicheranordnung mit mehreren Speicherzellenfeldern, von denen zu einer gegebenen Zeit jeweils ein Speicherzellenfeld in definierter Weise aktivierbar ist, mit einem Spannungsgenerator zur Lieferung eines Versorgungspotentials zu den Speicherzellenfeldern und mit ersten elektrischen Versorgungsleitungen zwischen dem Spannungsgenerator und den mehreren Speicherzellenfeldern und zweiten elektrischen Versorgungsleitungen zwischen den mehreren Speicherzellenfeldern.

Bisher sind bei integrierten Halbleiterspeicheranordnungen einzelne Speicherzellenfelder jeweils niederohmig über elektrische Versorgungsleitungen mit einem Spannungsgenerator verbunden, um den einzelnen Speicherzellenfeldern die jeweils notwendige Versorgungsspannung zur Verfügung zu stellen. Nun werden bei einer integrierten Halbleiterspeicheranordnung die einzelnen Speicherzellenfelder nacheinander in definierter Weise aktiviert, so daß zu einem gegebenen Zeitpunkt für ein gerade aktiviertes Speicherzellenfeld eine genau definierte Leistungsgröße zur Verfügung gestellt werden muß.

Das gerade aktivierte Speicherzellenfeld bildet so einen aktiven Bereich, während alle anderen Speicherzellenfelder zu der Zeit einer Aktivierung des einen aktivierten Speicherzellenfeldes inaktive Bereiche darstellen.

Für die Aktivierung eines Speicherzellenfeldes ist, wie Versuche gezeigt haben, die Umladung einer Kapazität von etwa 70 pF ausreichend, wobei in einer üblichen Halbleiterspeicheranordnung mit einer Vielzahl von Speicherzellenfeldern eine Kapazität von etwa 2 nF zur Verfügung steht.

Es ist nun Aufgabe der vorliegenden Erfindung, eine integrierte Halbleiterspeicheranordnung zu schaffen, die bei einfachem Aufbau sofort die für die Aktivierung eines Speicherzellenfeldes erforderliche Leistung mit kurzen Versorgungsleitungen zur Verfügung zu stellen vermag.

Diese Aufgabe wird bei einer integrierten Halbleiterspeicheranordnung der eingangs genannten Art erfindungsgemäß dadurch gelöst, daß die ersten Versorgungsleitungen hochohmig und die zweiten Versorgungsleitungen niederohmig ausgeführt sind.

Die Erfindung geht damit einen vom bisherigen Stand der Technik vollkommen abweichenden Weg: anstelle die Versorgungsleitungen zwischen dem Spannungsgenerator und den einzelnen Speicherzellenfeldern niederohmig zu gestalten, um somit eine rasche Bereitstellung der jeweils benötigten Leistung sicherzustellen, wird bei der erfindungsgemäßen integrierten Halbleiterspeicheranordnung gerade die Verbindung zwischen dem Spannungsgenerator und den einzelnen Speicherzellenfeldern hochohmig gestaltet. Dafür werden aber die Versorgungsleitungen zwischen den einzelnen Speicherzellenfeldern niederohmig ausgeführt. Auf diese Weise wird in vorteilhafter Weise die Gesamtkapazität aller gerade nicht aktivierten Speicherzellenfeldern ausgenutzt, um ein bestimmtes Speicherzellenfeld in einem gegebenen Zeitpunkt aktivieren zu können.

Auf diese Weise ist es möglich, den Verdrahtungsaufwand zu minimieren, ohne die elektrischen Parameter infolge Einbrüchen der Versorgungsspannung zu verschlechtern. Die "Selbstpufferung" eines ausgewählten Speicherzellenfeldes durch alle übrigen, zu diesem Zeitpunkt nicht aktivierten Speicherzellenfelder ist besonders vorteilhaft, da jeweils eine definierte Aktivierung, die genau vorherzusehen ist, vorliegt. Die Leistung, die für die Aktivierung eines bestimmten Speicherzellenfeldes benötigt wird, ist definiert und für die einzelnen Speicherzellenfelder gleich. Diese Leistung wird aus den Kapazitäten der gerade nicht aktivierten Speicherzellenfeldern bezogen. Die Speicherzellenfelder insgesamt sind über eine hochohmige Versorgungsleitung mit dem Spannungsgenerator verbunden, der so kontinuierlich die in den einzelnen Speicherzellenfeldern in deren Kapazitäten gespeicherte Leistung "auffrischt".

In vorteilhafter Weise sind die niederohmigen Versorgungsleitungen beidseitig längs der Reihe der Speicherzellenfelder geführt, während diese bisher lediglich an einer Seite mit einer hochohmigen Verbindungsleitung untereinander verdrahtet sind. Außerdem sind diese niederohmigen Versorgungsleitungen auch um die einzelnen Speicherzellenfelder angeordnet, so daß jedes einzelne Speicherzellenfeld von den niederohmigen Versorgungsleitungen "umrahmt" ist. Gegebenenfalls kann auch noch eine zusätzliche niederohmige Versorgungsleitung durch die Mitte der einzelnen Speicherzellenfelder geführt werden.

Die niederohmigen Versorgungsleitungen bestehen zweckmäßigerweise aus Leiterbahnen mit einer Breite von etwa 3 bis 4 µm und sind aus Aluminium und/oder Kupfer hergestellt.

Wesentlich an der vorliegenden Erfindung ist also die Verbindung der einzelnen Speicherzellenfelder untereinander durch niederohmige Versorgungsleitungen und der Anschluß dieser Speicherzellenfelder an einen Spannungsgenerator über eine hochohmige Versorgungsleitung. Außerdem sind die niederohmigen Versorgungsleitungen um die einzelnen Speicherzellenfelder herum ausgebildet, so daß deren niederohmige Versorgung gewährleistet ist. Wird ein bestimmtes Speicherzellenfeld aktiviert, dann wird die hierfür benötigte Leistung aus den übrigen, zu diesem Zeitpunkt inaktiven Speicherzellenfeldern bezogen. Die kontinuierliche Auffrischung der verbrauchten Leistung erfolgt über die hochohmige Versorgungsleitung zwischen den Speicherzellenfeldern und dem Spannungsgenerator.

Die erfindungsgemäße integrierte Halbleiterspeicheranordnung nutzt so eine Vielzahl von großflächigen Schaltungsgebieten darstellenden Speicherzellenfelder zur Pufferung der Versorgungspotentiale der wenigen, gleichzeitig aktivierten Bereiche in Form eines jeweils angesteuerten Speicherzellenfeldes. Die Verbindung dieser Schaltungsbereiche erfolgt dabei durch die ein "Power-Netzwerk" darstellenden niederohmigen Versorgungsleitungen bei Ankopplung dieses Netzwerkes an einen Spannungsgenerator über eine hochohmige Versorgungsleitung.

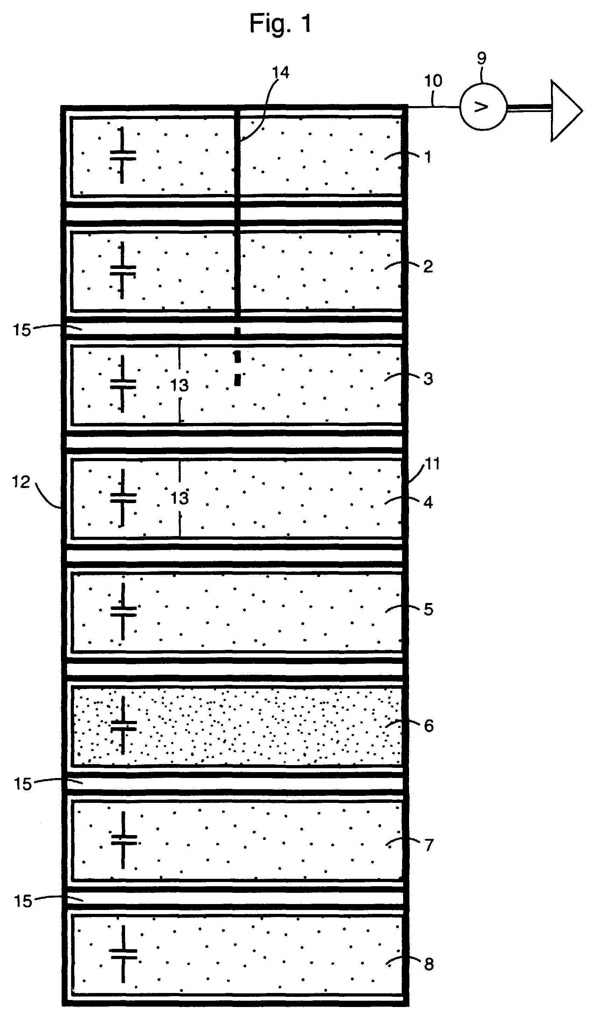

Nachfolgend wird die Erfindung anhand der Zeichnung näher erläutert, in deren einziger Figur eine integrierte Halbleiterspeicheranordnung in einem Blockschaltbild gezeigt ist.

Die erfindungsgemäße integrierte Halbleiterspeicheranordnung besteht aus Speicherzellenfeldern 1 bis 8, die in einer Reihe angeordnet und beidseitig untereinander über niederohmige Versorgungsleitungen 11, 12 mit einer Leiterbahnbreite von 3 bis 4 µm verbunden sind. Außerdem sind niederohmige Versorgungsleitungen 13 auch um die einzelnen Speicherzellenfelder 1 bis 8 herum geführt. Zusätzlich kann noch eine (oder mehrere) weitere niederohmige Versorgungsleitung 14 durch die Mitte der Speicherzellenfelder verlaufen.

In den Bereichen zwischen den Speicherzellenfeldern 1 bis 8 liegen jeweils Leseverstärker 15.

Die niederohmigen Versorgungsleitungen 11, 12, 13 und gegebenenfalls 14 bilden ein niederohmiges "Power-Netzwerk", das über eine hochohmige Leitung 10 mit einem Spannungsgenerator 9 verbunden ist.

Die niederohmigen Versorgungsleitungen 11 bis 13 und gegebenenfalls 14 bestehen aus Aluminium und/oder Kupfer und haben, wie bereits erwähnt wurde, eine Leiterbahnbreite von etwa 3 bis 4 µm.

Bei einer derartigen integrierten Halbleiterspeicheranordnung ist jeweils nur ein Speicherzellenfeld aktiviert, beispielsweise das Speicherzellenfeld 6. Die für diese Aktivierung benötigte Leistung bzw. Energie wird durch Selbstpufferung aus den Kapazitäten der übrigen Speicherzellenfelder 1 bis 5, 7 und 8 gewonnen. Diese Kapazitäten haben einen Kapazitätswert von etwa 2 nF, welcher vollkommen ausreichend ist, um die für die Aktivierung des Speicherzellenfeldes 6 benötigten 70 pF umzuladen.

Selbstverständlich können bei der erfindungsgemäßen integrierten Halbleiterspeicheranordnung auch verschiedene Zahlen von Speicherzellenfeldern miteinander verbunden sein. Auch brauchen diese Speicherzellenfelder nicht in einer Reihe zu liegen, wie dies bei dem Ausführungsbeispiel dargestellt ist. Wesentlich ist vielmehr, daß die einzelnen Speicherzellenfelder niederohmig untereinander verbunden sind, daß weiterhin jeweils nur ein Speicherzellenfeld oder mehrere Speicherzellenfelder, deren Anzahl aber klein gegenüber der Gesamtzahl der Speicherzellenfelder ist, aktiviert werden, wobei jeweils die gleiche Aktivierungsenergie für ein Speicherzellenfeld benötigt wird. Diese Energie bzw. Leistung wird durch Selbstpufferung aus den gerade nicht aktivierten Speicherzellenfeldern bezogen und infolge der niederohmigen Verbindung sofort dem zu aktivierenden Speicherzellenfeld zur Verfügung gestellt. Die hochohmige Verbindungsleitung 10 zu dem Spannungsgenerator 9 dient dazu, das Power-Netzwerk aus den niederohmigen Versorgungsleitungen 11 bis 13 und gegebenenfalls 14 kontinuierlich mit Leistung zu versorgen, um jeweils die Kapazitäten der Speicherzellenfelder aufzuladen.

## Patentansprüche

1. Integrierte Halbleiterspeicheranordnung mit mehreren Speicherzellenfeldern (1 bis 8), von denen zu einer gegebenen Zeit jeweils ein Speicherzellenfeld (z.B. 6) in definierter Weise aktivierbar ist, mit einem Spannungsgenerator (9) zur Lieferung eines Versorgungspotentials zu den Speicherzellenfeldern (1 bis 8) und mit ersten elektrischen Versorgungsleitungen (10) zwischen dem Spannungsgenerator (9) und den mehreren Speicherzellenfeldern (1 bis 8) und zweiten elektrischen Versorgungsleitungen (11 bis 14) zwischen den mehreren Speicherzellenfeldern,
**dadurch gekennzeichnet,** daß die ersten Versorgungsleitungen (10) hochohmig und die zweiten Versorgungsleitungen (11 bis 14) niederohmig ausgeführt sind.

2. Integrierte Halbleiterspeicheranordnung nach Anspruch 1,
**dadurch gekennzeichnet,** daß die zweiten Versorgungsleitungen (11 bis 14) beidseitig längs den eine Reihe bildenden Speicherzellenfeldern (1 bis 8) geführt sind.

3. Integrierte Haibleiterspeicheranordnung nach Anspruch 2,
**dadurch gekennzeichnet,** daß wenigstens eine zusätzliche zweite Versorgungsleitung (14) in der Mitte der Speicherzellenfelder (1 bis 8) geführt ist.

4. Integrierte Halbleiterspeicheranordnung nach einem der Ansprüche 1 bis 3,
**dadurch gekennzeichnet,** daß die zweiten Versorgungsleitungen (13) um die Speicherzellenfelder (1 bis 8) herum ausgeführt sind.

5. Integrierte Halbleiterspeicheranordnung nach einem der Ansprüche 1 bis 4,
**dadurch gekennzeichnet,** daß die zweiten Versorgungsleitungen (11 bis 14) eine Bahnbreite von etwa 3 bis 4 µm aufweisen.

6. Integrierte Halbleiterspeicheranordnung nach einem der Ansprüche 1 bis 5,
**dadurch gekennzeichnet,** daß die ersten und zweiten Versorgungsleitungen aus Aluminium und/oder Kupfer bestehen.
